Europäisches Patentamt

European Patent Office

Office européen des brevets

(19)

(11) Veröffentlichungsnummer: **0 040 754**
**B1**

(12) **EUROPÄISCHE PATENTSCHRIFT**

(45) Veröffentlichungstag der Patentschrift:
**11.03.87**

(51) Int. Cl.⁴: **H 05 K 5/00,** H 05 K 9/00

(21) Anmeldenummer: **81103654.0**

(22) Anmeldetag: **12.05.81**

(54) **Gerät zum Erfassen und Verarbeiten von elektrischen Signalen.**

(30) Priorität: **22.05.80 DE 3019668**

(43) Veröffentlichungstag der Anmeldung:
**02.12.81 Patentblatt 81/48**

(45) Bekanntmachung des Hinweises auf die Patenterteilung:
**11.03.87 Patentblatt 87/11**

(84) Benannte Vertragsstaaten:
**DE FR GB NL SE**

(56) Entgegenhaltungen:
**EP - A - 0 040 753**
**AU - B - 42 019**
**DE - A - 2 046 952**
**DE - B - 1 276 684**
**DE - B - 2 348 687**
**US - A - 3 199 938**
**US - A - 4 012 089**
**US - A - 4 038 625**

(73) Patentinhaber: **Siemens Aktiengesellschaft Berlin und München, Wittelsbacherplatz 2, D-8000 München 2 (DE)**

(72) Erfinder: **Rosenfeldt, Bernd, Bunsenstrasse 33, D-8520 Erlangen (DE)**
Erfinder: **Weller, Gerhard, Wacholderweg 13, D-8520 Erlangen (DE)**
Erfinder: **Wondra, Arthur, Kulmbacher Strasse 1, D-8520 Erlangen (DE)**
Erfinder: **Reis, Edmund, Richterstrasse 55, D-8520 Erlangen (DE)**

ACTORUM AG

## Beschreibung

Die Erfindung bezieht sich auf ein Gerät zum Erfassen und Verarbeiten von elektrischen Signalen mit einem Gerätegehäuse, das ein Signalverarbeitungsteil enthält und das wenigstens eine Einbuchtung aufweist, in die wenigstens ein Signalübertragungsteil mit einem Einschiebgehäuse mit einem Mantel aus Isolationsmaterial hoher Spannungsfestigkeit einschiebbar ist, wobei sowohl die Einbuchtung als auch das Einschiebgehäuse Träger von einander zugeordneten Primär- und Sekundärkoppelgliedern einer galvanisch getrennten Koppelstelle für Energie- und/oder Signalübertragung sind, welche Koppelglieder sich erst zur galvanisch getrennten Koppelstelle zusammenfügen, wenn das Einschiebgehäuse in die Einbuchtung eingeschoben ist.

Ein Gerät dieser Art ist beispielsweise durch das DE-U-7 736 156 (bzw. DE-C-2 752 783) bekannt. Bei diesem Gerät, bei dem es insbesondere um das Erfassen und Verarbeiten von physiologischen Messsignalen, wie EKG, Druck, Temperatur u.dgl., eines Patienten geht, ist die Einbuchtung aus nichtmagnetischem, jedoch elektrisch leitendem Material (z.B. Aluminium) gefertigt, und das dazu passende Einschiebgehäuse besteht vorzugsweise aus Kunststoff mit Innenmetallisierung. Mit diesem Aufbau ist ein besonders grossflächiger Steckkontakt geschaffen; es ergeben sich relativ lange Luft- und Kriechstrecken für möglicherweise fliessende Ableitströme. Die Spannungsfestigkeit ist um ein Vielfaches erhöht, und Isolationsprobleme treten nicht auf.

Darüber hinaus sind aus der allgemeinen Technik noch die GB-A-1 383 577, die GB-A-1 366 134 und die GB-A-1 447 469 nennenswert. Die GB-A-1 383 577 zeigt ein Gerät, das zur Übertragung von Energie- und Telemetriesignalen bei Schiffen eingesetzt wird. Ein wesentliches Merkmal der bei diesem Gerät eingesetzten Steckanordnung ist, dass sowohl die Einbuchtung als auch das Einschiebgehäuse aus einem Stapel von magnetischen Platten aufgebaut sind. Ein weiteres Merkmal ist, dass die Anordnung zum Gebrauch im Meereswasser vorgesehen ist. Zur Vermeidung eines direkten Kontaktes zwischen den magnetischen Platten und dem Seewasser ist neben einem den Magnetkreis unterbrechenden Luftspalt von mehreren Millimetern jeder Stapel der Magnetplatten auch noch mit einem Schutzmantel aus nicht näher bezeichnetem Material versehen. Das Gerät der GB-A-1 383 577 beschäftigt sich also insbesondere mit dem Problem des Schutzes einer Steckverbindung gegen Meereswasser. Das Problem der Spannungsfestigkeit und des besonders guten Schutzes gegen Ableitströme ist nicht angesprochen. Die anderen beiden Druckschriften GB-A-1 366 184 und GB-A-1 447 469 zeigen Beispiele für Koppelstellen, bei denen zur Übertragung von Energie Spulen als Primär- und Sekundärkoppelglieder sowie zur Übertragung von Signalen Lichtleiter als Primär- und Sekundärkoppelglieder verwendet werden.

Vorliegende Erfindung geht jedoch hinsichtlich der speziellen Problemstellung, nämlich dem Wunsch nach besonders hoher Spannungsfestigkeit bei optimaler Isolation der Koppelstelle, von einem Gerät gemäss DE-U-7 736 156 (bzw. DE-C-2 752 783) aus. Die in diesem Gerät eingesetzte Steckverbindung arbeitet optimal, sofern die Einbuchtung und das zur Einbuchtung passende Einschiebgehäuse in ihren Abmessungen in einem gewissen Dimensionierungsbereich verbleiben. Überschreiten die Abmessungen jedoch diesen Dimensionierungsbereich, d. h. werden Einbuchtung und Einschiebgehäuse noch grossvolumiger bzw. grossflächiger ausgestaltet, so treten erneut Probleme hinsichtlich des Ableitstromes auf. Der Ableitstrom steigt in unerwünschter Weise.

Aus der US-A-4 012 089 ist ein Gerätegehäuse aus Isolationsmaterial hoher Spannungsfestigkeit bekannt, das Einbuchtungen zum Einschieben von Einschiebgehäusen aufweist, wobei das Gerätegehäuse mit sich in Einschubrichtung erstreckenden, an den inneren Längskanten der Einbuchtungen befindlichen Führungsschienen für die Einschiebgehäuse versehen ist. Eine in Fig. 2 dieser Druckschrift eingezeichnete, im Text jedoch nicht erwähnte Vorrichtung, die an der Rückwand des Einschiebgehäuses als zwei zusammenhängende Rechtecke und an der Innenrückwand des Gerätegehäuses als Rechteck gezeichnet ist, könnte möglicherweise eine Steckvorrichtung, bestehend aus Stecker und Dose, darstellen. Diese Steckvorrichtung wäre bei nicht vollständig eingeschobenem Einschiebgehäuse eine galvanisch trennende, im vollständig eingeschobenen Zustand aber eine galvanisch verbindende Koppelstelle. Demgegenüber betrifft die vorliegende Erfindung eine auch im eingeschobenen Zustand des Einschiebgehäuses galvanisch getrennte Koppelstelle.

Aufgabe vorliegender Erfindung ist es, ein Gerät der eingangs genannten Art anzugeben, das grossvolumig bzw. grossflächig dimensionierte Kombinationen aus Einbuchtung und Einschiebgehäuse zulässt, ohne dass gleichzeitig ein möglicherweise fliessender Ableitstrom einen unzulässigen hohen Wert einnimmt.

Diese Aufgabe wird erfindungsgemäss dadurch gelöst, dass die Einbuchtung im Gerätegehäuse mit einem Isolierkörper aus Isolationsmaterial hoher Spannungsfestigkeit ausgekleidet ist oder dass ein solcher Isolierkörper selbst die Ausbuchtung bildet, dass der Innenraum des Isolierkörpers durch Längsschienen in eine Anzahl von Etagen gegliedert ist, die jeweils zur Aufnahme eines der Einschiebgehäuse bestimmt sind, und dass der Isolierkörper an seinem Umfang Rippen aufweist, die einen vorgegebenen Isolationsabstand zwischen der Innenwand des Isolierkörpers und der Umgebung festlegen.

Die Erfindung geht von der Erkenntnis aus, dass eine grossvolumigere bzw. grossflächigere Ausbildung der Kombination aus Einbuchtung und Einschiebgehäuse bei direktem Kontakt zwischen beiden zu einem rapiden Anstieg der Kapazität zwischen Metallteilen der Einbuchtung und Metallteilen des Einschiebgehäuses führt. Der höhere Kapazitätswert verursacht einen höheren Wert des Ableitstromes, sofern ein solcher fliesst. Die Erfindung vermeidet diesen Nachteil durch Einsatz des Isolierkörpers. Ein solcher Isolierkörper verkleinert die Kapazität; auch bei relativ grossvolumiger oder grossflächiger Ausbildung der Gehäuse der Steckverbindung bleibt der Ableitstromwert gering.

In vorteilhafter Ausgestaltung der Erfindung kann eine aus nichtmagnetischem, jedoch elektrisch leitendem Material, z. B. Aluminium- oder Stahlblech, gebildete Einbuchtung mit einem Isolierkörper ausgekleidet sein. Ebensogut kann ein Isolierkörper, der selbst die Einbuchtung bildet, an seinen Aussenwandungen wenigstens teilweise, vorzugsweise jedch ganzseitig, mit Platten aus nichtmagnetischem, jedoch elektrisch leitendem Material, z. B. Aluminium- oder Stahlblech, ummantelt sein. Besonderes Interesse besteht auch daran, dass ein Isolierkörper geschaffen wird, der nur geringe Kapazitätswerte schafft und der dennoch im Aufbau relativ einfach und gleichzeitig auch preiswert ist. In vorteilhafter Ausgestaltung der Erfindung wird dies dadurch erreicht, dass die Rippen die Innenwandung des Isolierkörpers unter Einschluss von Isolierschichten aus Luft im vorgegebenen Abstand vom elektrisch leitenden Material der Gehäuseeinbuchtung oder von den den Isolierkörper als Einbuchtung umkleidenden Platten halten. Der «Rippenkörper» ist dabei zweckmässigerweise aus ausgesuchtem Isoliermaterial mit bestimmter Dielektrizitätskonstante (insbesondere ABS = Amino-Butadien-Styrol) so geformt, dass er die zwischen Metallteilen im Inneren und Metallteilen im Aussenraum herrschende Kapazität auf einen Wert unterhalb 130 pF (bezogen auf eine Betriebsspannung von 220 V und 50 Hz) begrenzt. Der «Rippenkörper» begrenzt also den Wert der Kapazität bei einem Minimum an Materialaufwand. Bei relativ einfachem Aufbau des Isolierkörpers wird also erheblich Material gespart, so dass der Isolierkörper insgesamt auch besonders preiswert wird.

Das Einschiebgehäuse wird im folgenden gelegentlich kurz als «Einschub» bezeichnet. Weitere Vorteile und Einzelheiten der Erfindung ergeben sich aus der nachfolgenden Beschreibung eines Ausführungsbeispiels anhand der Zeichnung in Verbindung mit den Unteransprüchen.
Es zeigen:

Figur 1 ein Gerät gemäss der Erfindung in Schrägansicht,

Figur 2 einen aus zwei Halbschalen aufgebauten Isolierkörper,

Figur 3 den Isolierkörper mit montierter Rückplatte in teilgebrochener Ansicht,

Figur 4 eine Seitenansicht des Isolierkörpers mit einem Arretierhebelsystem für die Einschübe im Isolierkörper,

Figur 5 einen erfindungsgemässen Einschub in Schrägansicht,

Figur 6 die Rückfläche eines Einschubes gemäss Figur 5,

Figur 7 einen Auswerfmechanismus für Einschübe an der Rückfläche des Isolierkörpers,

Figur 8 den inneren Aufbau eines Einschubes und

Figur 9 eine Koppelstelle für Energieankopplung, teilweise im Schnitt.

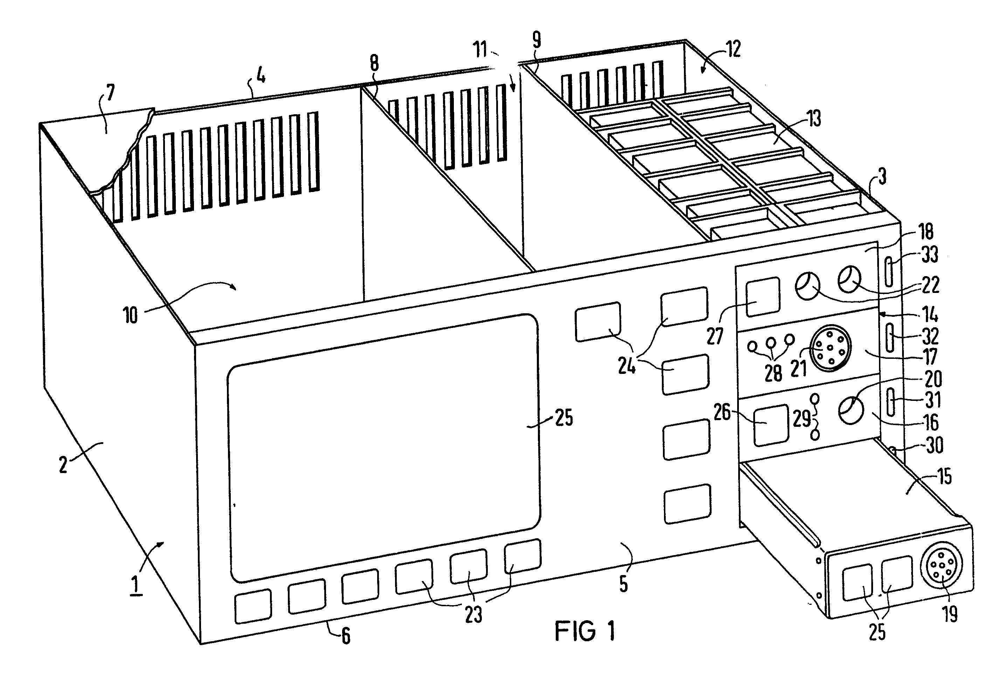

Die Figur 1 zeigt das Gerät mit einem im Zollmass aufgebauten Gerätegehäuse 1 mit den Seitenwänden 2 und 3, der Rückwand 4 und Frontfläche 5, der Grundfläche 6 sowie der nur gebrochen angedeuteten Deckfläche 7. Das Gerätegehäuse 1 ist durch z. B. zwei Zwischenwände 8, 9 in seinem Inneren in drei Kammern 10, 11 und 12 unterteilt. In der Kammer 10 sitzt beispielsweise eine (nicht dargestellte) Kathodenstrahlröhre zur Darstellung von Signalen. Die Kammer 11 nimmt z.B. Leiterplatten mit Bauelementen zur Signalverarbeitung bzw. Signalanzeige auf. Die Kammer oder Einbuchtung 12 dient hingegen zur Aufnahme des erfindungsgemässen Isolierkörpers 13, der als frontseitig offener Kasten ausgebildet ist, in dessen Inneren von der Frontöffnung 14 her insgesamt vier Geräteeinschübe 15, 16, 17 und 18 einschiebbar sind. Die Kammer 12 des Gerätegehäuses 1 kann damit also z.B. als Einbuchtung definiert werden, die mit einem Isolierkörper 13 ausgekleidet ist, der wiederum zur Aufnahme von Einschüben dient. Ebensogut kann jedoch auch der Isolierkörper 13 selbst als Einbuchtung bezeichnet werden, die zur Aufnahme von Geräteeinschüben dient. Die Geräteeinschübe sind Bestandteil des Signalübertragungssystems. Sie können im Inneren schaltungsmässig so aufgebaut sein, wie beispielsweise im DE-U-7 736 156 (bzw. DE-C-2 752 783) ausführlich beschrieben ist. Wesentlich ist jedoch, dass jeder Einschub einen Mantel aus Isolationsmaterial hoher Spannungsfestigkeit aufweist, der in seinem Inneren neben den Leiterplatten mit Bauelementen und Metallabschirmung für diese Bauelemente auch noch die ersten Halbglieder einer Koppelstelle für Energie- und Signalübertragung trägt, während die dazu passenden zweiten Halbglieder speziell in der Rückfläche des Isolierkörpers 13 mit Verbindung zum freien Raum der Kammer 12 sitzen, wie im Detail später noch näher erläutert wird.

Das in der Figur 1 dargestellte Gerät ist speziell ein elektromedizinisches Gerät. Die Einschübe 15 bis 18 sind also Teil des Signalübertragungssystems für physiologische Signale, die mittels geeigneter Abnehmer am Körper eines Patienten abgenommen werden. Zu diesem Zwecke werden also (nicht dargestellte) Abnehmer am Körper des Patienten positioniert und über ein Signalkabel (ebenfalls nicht dargestellt) am jeweiligen Einschub 15 bis 18 angekoppelt. Die Einschübe 15 bis 18 weisen zu diesem Zweck Steckbuchsen 19 bis 22 für die entsprechenden Stecker der Signalkabel auf. Selbstverständlich ist auch der Einsatz von Einschüben möglich, bei denen die Abnehmer über Signalkabel mit dem jeweiligen Einschub immer fest (also nicht in Steckverbindung) verbunden sind. Letzterer Fall bietet sich an, wenn das einzelne Einschubgehäuse relativ kleinvolumig ausgebildet ist. Der Einschub mit dem fest angeschlossenen Kabel ist dann selbst als Gerätestecker aufzufassen.

Im Ausführungsbeispiel der Figur 1 ist die Frontplatte 5 als Folienplatte ausgebildet. Sämtliche Bedienungs- und/oder Anzeigeelemente liegen also in der Ebene der Folie, wie durch die Symbole 23, 24 angedeutet ist. Dasselbe gilt auch für das Bildfenster 25 für den Bildschirm der zu montierenden Kathodenstrahlrohre bzw. auch für die Frontflächen der eingeschobenen Einschübe 15 bis 18. Auch die Frontflächen der Einschübe liegen damit zusammen mit den ebenfalls nur schematisch dargestellten eingebauten Bedien- und Anzeigeelementen 25 bis 29 (28 und 29 sind z.B. Leuchtdioden) in der Folienebene der Frontplatte 5. Die Anordnung in einer Ebene verbietet das Anbringen von Griffen an den Einschüben, mit deren Hilfe eingesteckte Einschübe aus der Ausbuchtung des Gerätegehäuses wieder herausgezogen werden können. Um dennoch ein schnelles Auswechseln von Einschüben gewährleisten zu können, ist deshalb jeder Einschub speziell mit einem Auswerfmechanismus an der Rückwand des Isolierkörpers 13 versehen, der in Aktion tritt, wenn eine Arretiervorrichtung, die den Einschub im Hohlraum nach Einschieben arretiert, durch manuelle Betätigung einer am Gerätegehäuse angeordneten Ausklinktaste gelöst wird. Die einzelnen Ausklinktasten für die Einschübe sind in der Figur 1 an der äussersten rechten Kante der Frontplatte 5 mit den Kennziffern 30 bis 33 angedeutet. Weitere Details hinsichtlich Aufbau und Funktionsweise des Auswerfmechanismus in Verbindung mit der Arretiervorrichtung werden weiter unten beschrieben. In dem Ausführungsbeispiel der Figur 1 ist 15 beispielsweise ein $CO_2$-Einschub, 16 ein Einschub für Druckmessung, 17 ein Einschub für EKG-Messung und 18 ein Temperatureinschub. Selbstverständlich ist auch der Einsatz eines jeden anderen Einschubes für eine andere Messgrösse möglich.

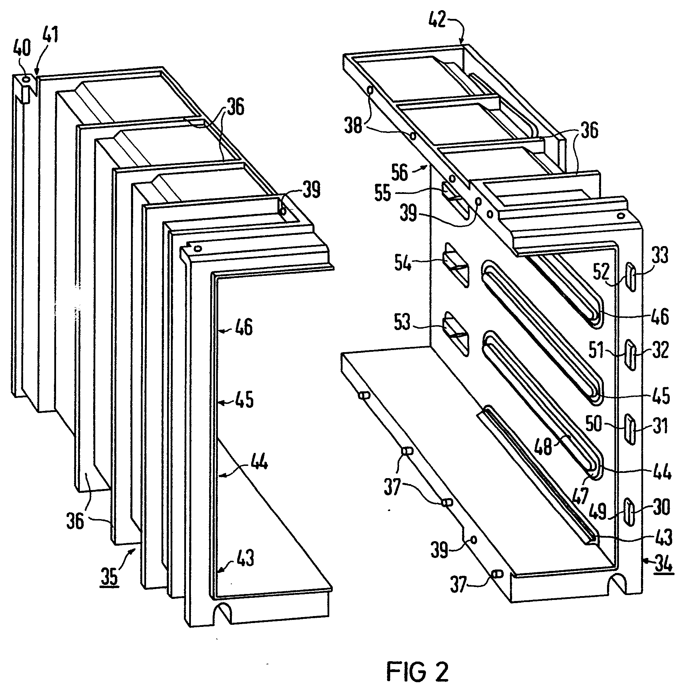

Gemäss der Figur 2 setzt sich der Umfang des Isolierkörpers 13 aus zwei Halbschalen 34 und 35 zusammen. Beide Halbschalen sind aus dem Kunststoff Amino-Butadien-Styrol (ABS) gefertigt, der sich leicht formen lässt und zudem auch relativ preisgünstig ist. Um bei relativ grosser Aussenfläche des Isolierkörpers 13 mit möglichst wenig Isoliermaterial auskommen zu können, sind die beiden Halbschalen 34 und 35 speziell als «Rippenkörper» geformt. Jede der Schalen 34 und 35 umfasst also an ihrem Umfang Rippen 36, die die Innenwandung des Isolierkörpers unter Einschluss von Isolierschichten aus Luft zwischen den Rippen in vorgebbarem Abstand von den Metallwänden der Gehäusekammer 12 halten. Im vorliegenden Fall beträgt die Tiefe der Rillen insbesondere an den Seitenwänden der Halbschalen ca. 7 mm. An den Ober- und Unterflächen der Halbschalen sinkt die Tiefe aus montagetechnischen Gründen auf einen Wert bis etwa 3 mm. Die Dicke der Rippen beträgt ca. 1,5 mm. Die Materialbreite der Innenwandung der Halbschalen beträgt ca. 3 mm. Der aus beiden Halbschalen 34 und 35 zusammengesetzte Isolierkörper besitzt eine Aussenbreite von 2/8″, von Aussenrippen zu Aussenrippen gemessen. Die Höhe des kastenförmigen Isolierteils liegt bei ca. 180 mm (entsprechend vier Höheneinheiten HE). Diese Bemessung des Rippenkörpers 13 und die Auswahl des entsprechenden isolierenden Kunststoffes führen im vorliegenden Ausführungsbeispiel dazu, dass die Kapazität zwischen Metallteilen innerhalb des Gehäuses der Einschübe 15 bis 18 und Metallteilen ausserhalb des Isolierkörpers 13 (Abschirmwände der Kammer 12 des Gerätegehäuses bzw. an der Rückwand des Isolierkörpers 13 befindliche Metallteile), bezogen auf eine Betriebsspannung von 220 V und 50 Hz, auf einen Wert < 130 pF begrenzt wird. Bei dieser Kapazität ist ein möglicherweise fliessender Ableitstrom ungefährlich niedrig (< 10 µA).

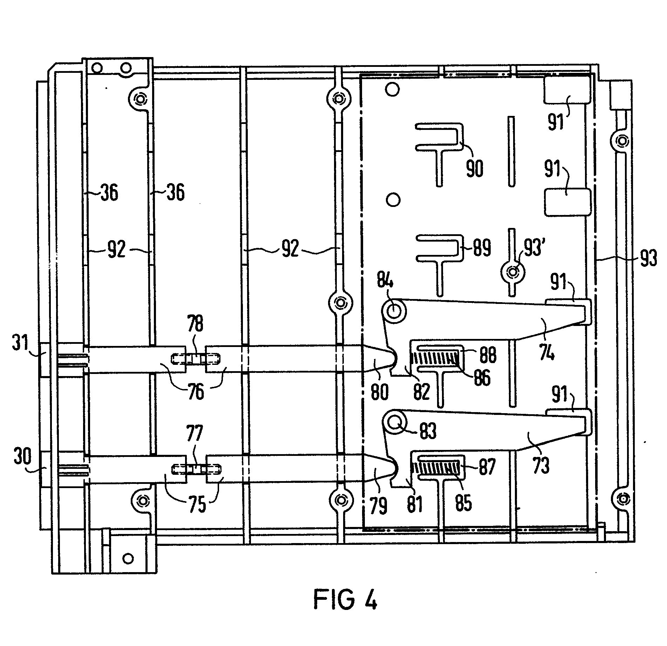

In der Figur 2 umfassen die beiden Halbschalen 34 und 35 des Isolierkörpers an den einander zugewandten Montierkanten Bolzen 37 an jeweils einer Montierkante des einen Halbteiles, die zu entsprechenden Justierlöchern 38 an der Gegenkante des anderen Halbteiles passen. Nach Zusammenfügen der beiden Halbschalen 34 und 35 werden diese an den Aneinandersetzleisten frontseitig über Schraublöcher 39 auf der Deckseite und entsprechende Schraublöcher 39 auf der Grundseite mit je einer Schraube miteinander verschraubt. Entsprechendes gilt für zwei Eckschraublöcher 40 im hinteren Teil der Deckfläche der Halbschalen, die über entsprechende Ecklöcher an der Oberkante einer ansetzbaren Rückwand mit der Rückwand verschraubbar sind. Die Unterflächen der beiden Halbschalen werden hingegen rückseitig durch eine spezielle Ausformung der Rückwand zusammengepresst, die in zwei Nuten 41, 42 an den rückseitigen Längskanten der zusammengesetzten Halbschalen 34 und 35 einschiebbar ist. Bei eingeschobener Rückwand bildet dann der aus den beiden Halbschalen zusammengesetzte Isolierkörper 13 einen frontseitig offenen Kasten, in den die Einschübe eingeschoben werden können. Zum etagenmässigen Einschieben der einzelnen Einschübe 15 bis 18 haben die beiden Halbschalen an ihrer Innenwandung Längsschienen 43 bis 46. Diese Längsschienen sind so geformt, dass auf eine relativ flache Wandauswölbung 47 ein stärker ausgewölbter Längssteg 48 (dargestellt am Beispiel der Schiene 44) folgt. Dies hat zum Ergebnis, dass der einzuschiebende Einschub, getragen vom jeweiligen Steg 48 einer Führungsschiene 43 bis 46, nur auf der leichten Auswölbung 47, d.h. nicht mit der gesamten Seitenfläche an der Innenwand des Isolierkörpers, gleitet. Hierdurch ergibt sich eine besonders reibarme Bedienweise des Einschubes. Die Stegauswölbungen sind leicht abgerundet; der ausgewölbte Mittelsteg 48 passt zu einer entsprechenden Gleitrille an den Längskanten eines jeden Einschubes. Gleitstege 43 bis 46 und Längsrillen an den Einschüben sorgen aufgrund ihrer Abgerundetheit nicht nur für reibarmes Gleiten; die abgerundeten Stege und Gleitrillen vermeiden auch scharfe Kanten, an denen sich leicht Schmutz ansetzt. Diese Art von Gleitlagerung ist also auch nach Gesichtspunkten der Reinlichkeit optimal ausgelegt. In der Figur 2 sind schliesslich an der rechten Aussenkante der Halbschale 34 die Ausklinktasten für das Arretierhebelsystem wieder mit 30 bis 33 angedeutet. Die Tasten 30 bis 33 ragen dabei nur um einen solchen Wegbetrag aus Öffnungen 49 bis 52 der Kante der Halbschale 34 hervor, dass nach Montage des Isolierkörpers in der Kammer 12 des Gerätegehäuses 1 bei Abdekkung der Frontfläche 5 mit der Folie die Stirnfläche jeder Klinktaste in etwa in der Ebene der Abdeckfolie der Frontplatte 5 liegt. Die Betätigung einer Ausklinktaste 30 bis 33 erfolgt dann durch Druck auf die Folie an der Stelle der Ausklinktaste. Das Drücken einer Ausklinktaste 30 bis 33 bewirkt, dass speziell im vorliegenden Fall über ein Hebelsystem ein Klinkhebel betätigt wird. Die Arretiernasen der jeweiligen Klinkhebel, die im eingeschobenen Zustand des Einschubes in eine Nut an einer Seitenkante des Einschubes eingreifen, sind in der Figur 2 an der hinteren Innenseite der rechten Halbschale mit 53 bis 56 angedeutet. Nähere Einzelheiten über Aufbau und Funktionsweise der Arretiervorrichtung ergeben sich aus der noch folgenden Beschreibung zur Figur 4.

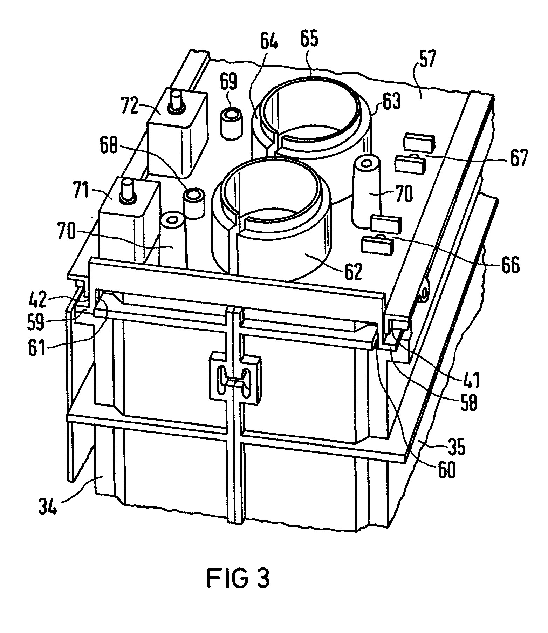

Die Figur 3 zeigt in teilweise gebrochener Ansicht die zum Ganzkörper zusammengefügten Halbschalen 34 und 35 schräg von unten und gegenüber der Darstellung der Figur 2 um ca. 180° gedreht. Mit eingezeichnet ist jetzt die in die Nuten 41 und 42 eingeschobene Rückplatte 57. Die Nutstege 58 und 59 dieser Rückplatte gleiten am untersten Ende kurz vor vollständigem Einschieben der Platte über zwei leicht geschrägte Flächen 60 und 61 an der hinteren Unterkante der Unterflächen der beiden Halbschalen 34 und 35. Die Nutstege üben damit an ihren Unterkanten über die zunehmende Schrägfläche 60 bzw. 61 Druck auf die Unterseiten der beiden Halbschalen aus. Die beiden Halbschalen werden an dieser Stelle zusammengedrückt und haften damit gut aneinander. Die Rückplatte 57 besteht ebenfalls aus Kunststoff, vorzugsweise wieder ABS. Sie ist nicht nur rückwärtiges Abschlussteil des Isolierkörpers 13; vielmehr dient die Rückplatte 57 auch als Träger jener Teilglieder der Koppelstelle, die als geräteseitige Halbteile zu den Halbteilen im Inneren der Einschübe passen. In der Figur 3 weist also die Rückplatte insgesamt vier Aufnahmezylinder für Koppelglieder zur Energieübertragung auf, von denen allerdings wegen der teilgebrochenen Darstellung nur zwei zu sehen sind, die mit 62 und 63 bezeichnet sind. Der obere, der Rückplatte 57 abgewandte Rand eines jeden Montagezylinders 62, 63 etc. ist stegartig verdünnt. Die Schulter 64 der Stegverdünnung des Oberrandes dient dabei als Auflage für eine Montageplatte, die durch den eigentlichen Oberrand-Rundsteg 65 zentriert wird. Die Montageplatte ist wiederum Träger der Koppelglieder in schwimmender Aufhängung; sie selbst sitzt auf einer Leiterplatte, auf der die für die Energieübertragung bzw. Signalübertragung erforderlichen elektronischen Bauelemente montiert sind. Im vorliegenden Falle erfolgt die Signalübertragung vom Einschub Richtung Signalverarbeitungsteile des Gerätes mittels Lumineszenzdioden vorzugsweise im Infrarotbereich. Zu diesem Zwecke sind für insgesamt vier Sendedioden, die als primäre Signalkoppelglieder im jeweiligen Einschub 15 bis 18 angeordnet sind, auf der Rückplatte 57 vier geräteseitige Lichtempfänger (z. B. Fotodioden) als sekundäre Signalkoppelglieder vorgesehen. Die Montagenischen für die Lichtempfänger sind auf der Montageplatte 57 mit den Kennziffern 66, 67 etc. angegeben. Entsprechend sind auch für Signalübertragung (Schalt- oder sonstige Steuersignale) vom Inneren des Gerätegehäuses in Richtung Einschübe auf der Rückplatte 57 des Isolierkörpers Einsätze 68, 69 etc. für Sendedioden vorgesehen. Die dort einzusetzenden Lumineszenzdioden sind dann die primären Koppelglieder für den Sendefall; die zugeordneten Empfänger sitzen als sekundäre Koppelglieder innerhalb des Einschubgehäuses. Wird also ein Einschub 15 bis 18 in eine Etage des Isoliergehäuses 13 bis in seine Endstellung eingeschoben, so ergibt sich automatisch Koppelverbindung zwischen Koppelgliedern für Energieübertragung vom Gerät zum Einschub und Koppelgliedern für Signalübertragung sowohl vom Einschub in Richtung Gerätegehäuse als auch vom Gerätegehäuse in Richtung Einschub. Im Ausführungsbeispiel der Figur 3 umfasst darüber hinaus die Rückplatte 57 noch Schraubfüsse 70 zum Festschrauben der die Montageplatte tragenden Leiterplatte, und an der linken Seite der Platte 57 sind die ersten beiden Auswerfer 71 und 72 von insgesamt vier Auswerfern für je einen Einschub zu sehen.

Die Figur 4 zeigt, wie schon vorstehend angedeutet, die, von der Öffnung her gesehen, rechte Seitenwand des Isolierkörpers 13, an der das Hebelsystem für die Arretierung der einzelnen Einschübe 15 bis 18 montiert ist. Dieses Hebelsystem umfasst dabei für jeden Einschub einen Klinkhebel 73, 74 etc. mit den in der Figur 2 dargestellten Arretiernasen 53 bis 56. Jedem Klinkhebel 73, 74 etc. ist ein Betätigungshebel 75, 76 etc. zugeordnet, der bei Druck auf die endständige Ausklinktaste 30, 31 etc. ausgelenkt wird und den Klinkhebel betätigt. Jeder Auslenkhebel 75, 76 etc. besteht dabei aus zwei Teilen, die durch je eine Justierschraube 77, 78 etc. auf eine gewünschte Gesamtlänge des Hebels einjustierbar sind. Jeder Auslenkhebel 75, 76 etc. stösst darüber hinaus über ein zugespitztes Ende 79, 80 etc. in eine Mulde des der Arretiernase abgewandten, um etwa 90° abgekröpften Endes des Klinkhebels 73, 74 etc. Bei Druck auf diese Mulde wird demnach der Hebel um sein Drehgelenk 83, 84 etc. gegen den Druck einer Feder 85, 86 etc., die in einer Nische 87, 88, 89, 90 der Seitenwand gelagert ist, einwärts geschwenkt. Diese Einwärtsschwenkung des einen Hebelendes führt zu einer Aufwärtsschwenkung des anderen Hebelendes mit der Arretiernase 53 bis 56. Die durch die Seitenwandöffnung 91 in das Innere des Isolierkörpers 13 greifende Arretiernase 53 bis 56 wird nach oben angehoben. Die Arretiernase springt aus der entsprechenden Arretiernut des Einschubes, und der Einschub wird im selben Augenblick durch den Auswerfmechanismus aus dem Isoliergehäuse ausgeworfen. Bei der Arretiervorrichtung der Figur 4 sind die Längshebel 75, 76 etc. in Nischen 92 der Rippen der Seitenwand eingelagert. Zur Sicherung der Klinkhebel 73, 74 nebst Federn 85, 86 gegen Herausspringen aus ihren Halterungen dient eine (strichpunktiert dargestellte) Kunststoffplatte 93, die in einem Schraubloch 93' an der Seitenwand des Isoliergehäuses über den Hebeln und Federn angeschraubt wird.

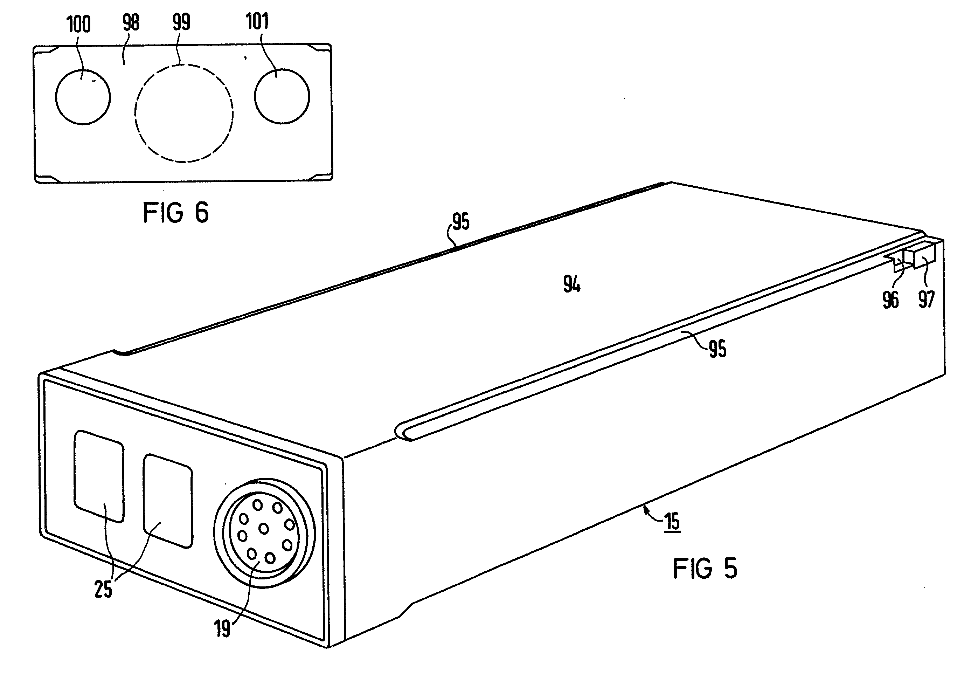

Die Figur 5 zeigt das Ausführungsbeispiel eines Einschubes, beispielsweise des Einschubes 15 in der Figur 1. Jeder der Einschübe umfasst ein nur frontseitig offenes Mantelgehäuse 94 aus hochisolierendem Kunststoff, z.B. wieder ABS. Der hochisolierende Mantel 94 ist entlang seinen Längskanten mit den schon erwähnten wohlgerundeten und deshalb auch leicht zu säubernden Gleitrinnen 95 versehen. Am hinteren Ende der rechten oberen Kante des Einschubmantels 94 befindet sich die Klinknut 96, in die ein Block 97 aus hartem Kunststoff, insbesondere Polyamid-Glasfaser, eingeklebt ist. Der harte Block 97 schützt die Einklinknut 96 gegen allzu starke Beanspruchung durch die Arretiernase des Klinkhebels. Die Frontöffnung des Mantelgehäuses 94 eines jeden Einschubes ist mit einer Einschubfrontplatte dicht abgeschlossen. Die Figur 6 zeigt die Rückwand 98 des Mantelgehäuses 94. Diese Rückwand ist im Zentrum 99 (gestrichelt angedeutet) im Material scheibenartig verdünnt. Die Verdünnung an dieser Stelle gewährleistet eine besonders enge Ankopplung des dahinterliegenden Übertragerkörpers auf der Seite des Einschubes an jenen auf der Seite des Gerätes an der Rückplatte des Isolierkörpers in der Endstellung des Einschubes. Mit 100 und 101 sind zwei Fenster für das Infrarotlicht der beiden Signalübertragungskoppler eines jeden Einschubes angedeutet. Bei dem Fenster handelt es sich um rot eingespritzten Kunststoff oder um ein echtes Infrarotfilter. Die beiden Fenster sind wasser- und luftdicht sowie hochspannungsfest durch Ultraschall in die Rückwand 98 eingeschallt.

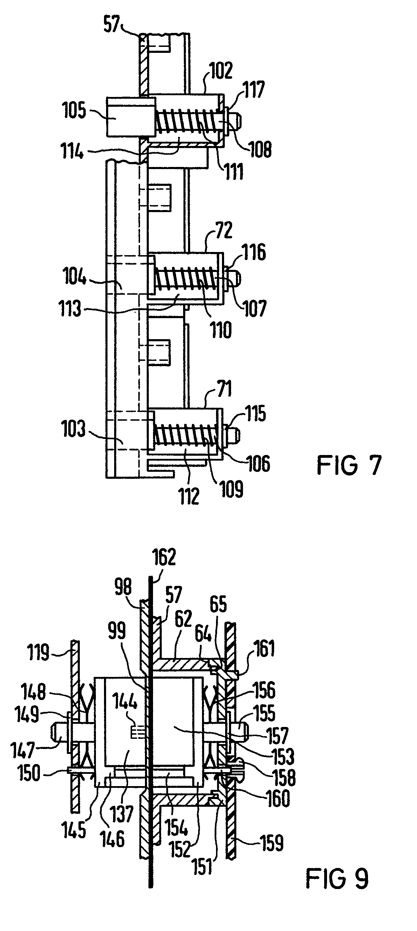

Die Figur 7 zeigt im Detail den Auswerfmechanismus an der Rückplatte 57 des Isolierkörpers. Zusätzlich zu den Auswerfblöcken 71, 72 der Figur 3 ist noch ein dritter Auswerfblock 102 dargestellt. Ein vierter Auswerfblock ist wegen der gebrochenen Darstellung nicht mehr mit eingezeichnet. Jeder Block 71, 72, 102 etc. umfasst ein Stossglied 103, 104, 105 etc. Jedes dieser Stossglieder ist mit einem Stössel 106, 107, 108 etc. verbunden, der durch eine Schraubenfeder 109, 110, 111 etc. im Innenraum 112, 113, 114 etc. der jeweiligen Auswerfblöcke federnd gehaltert ist. Zur äusseren Sicherung der Stössel dienen Sicherungsringe 115, 116, 117 etc. Wird ein Einschub in die ihm zugeordnete Etage des Isoliergehäuses 13 eingeschoben, so wird durch die Rückwand des Einschubes das sich in Höhe dieser Etage befindende Stossglied 103 bis 105 samt Stössel 106 bis 108 etc. gegen den Druck der den Stössel umgreifenden Feder 109 bis 111 nach hinten geschoben. Der in seiner Endstellung schliesslich durch die Arretiernase 53 bis 56 des Klinkhebels 73, 74 etc. in seiner Rastnut 96 festgehaltene Einschub drückt nun so lange auf das Stossglied 103 bis 105 etc.,

bis durch Druck auf die zugehörige Ausklinktaste 30 bis 33 des Arretierhebelsystems die Arretierung durch den Klinkhebel gelöst wird. Die Federkraft der gespannten Feder 109 bis 111 sorgt dann dafür, dass der Einschub durch das Ausstossglied 103 bis 105 aus dem Inneren des Isolierkörpers zumindest so weit herausgestossen wird, dass er an seiner Frontseite von Hand bequem ergriffen und herausgezogen werden kann. Jeder Stössel betätigt in bevorzugter Ausbildung auch noch einen Schalter, insbesondere Mikroschalter, in dem Sinne, dass mit Auswerfen eines Einschubes die Stromzufuhr zum Primärübertrager auf der Geräteseite unterbrochen wird.

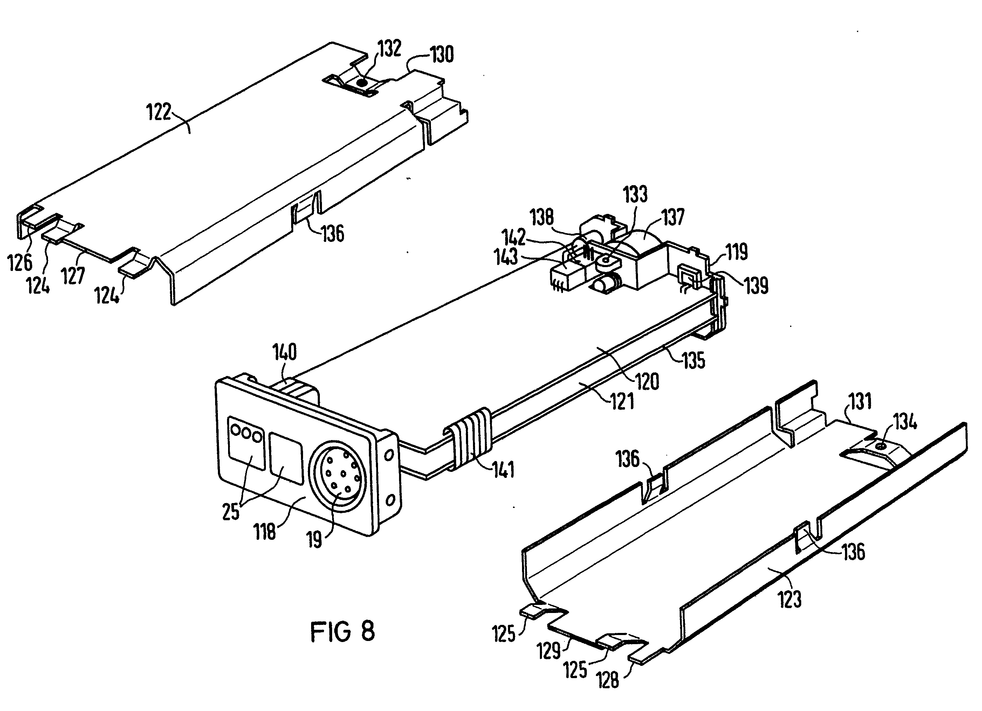

Die Figur 8 zeigt als Ausführungsbeispiel den inneren Aufbau eines Einschubes 15 bis 18. Dieser innere Aufbau ist dadurch gekennzeichnet, dass zwischen dem Frontteil 118 des Einschubes und einem Rückteil 119 nach Art einer Steckverbindung insgesamt zwei Leiterplatten 120 und 121 gehalten sind. Auf diesen Leiterplatten sind die wesentlichen elektronischen Bauelemente für Energie- und Signalübertragung montiert. Dieser Teilaufbau aus Front- und Rückfläche sowie Leiterplatten ist schliesslich nach Sandwich-Art durch zwei metallische Abschirmbleche 122 und 123 (z.B. aus Aluminium oder Stahlblech) abgedeckt. Beide Abschirmbleche 122 und 123 sind an der Vorderkante mit Klauen 124 bzw. 125 versehen. Bei Auflage des jeweiligen Bleches mit den ebenen Kanten 126, 127 bzw. 128, 129 auf die Innenschulter der Frontplatte 118 greifen die Klauen 124 bzw. 125 in Ausnehmungen unterhalb der Schulter, so dass sich an der Schulter eine Art Klemmverbindung zur Halterung der Vorderkante der beiden Bleche 122 und 123 ergibt. Die Rückkanten 130 bzw. 131 der Bleche 122 und 123 liegen hingegen auf den Kanten des Rückteils 119 auf. Sie werden über Schraublöcher 132, 133 bzw. 134, 135 mit dem Rückteil verschraubt. Die mittleren Teile der Abschirmbleche 122, 123 liegen über Klauen 136 federnd an den Seitenkanten der Leiterplatten 120 und 121 an. Im Ausführungsbeispiel der Figur 8 ist das Rückteil 119 zum Zwecke der Abschirmung aus metallisiertem Kunststoff gefertigt. Das Rückteil 119 ist gleichzeitig Träger von Koppelgliedern zur Energie- und Signalübertragung. So trägt es u.a. in schwimmender Aufhängung einen Schalenkern zur Aufnahme eines Spulenkörpers als Sekundärteil eines Koppelgliedes für Energieübertragung vom Gerät zum Einschub. Zur Signalübertragung vom Einschub zum Gerät sind an der linken Seite ein Einsatz für eine Sendediode 138 (Lumineszenzdiode) und zur Signalübertragung vom Gerät zum Einschub auf der rechten Seite eine Nische für einen Lichtempfänger 139 (Fotodiode) angeordnet. Zur leitungsmässigen Verbindung zwischen Vorderplatte 118 (Folienfrontplatte mit integrierten Schaltern) des Einschubes und Leiterplatten 120, 121 dient ein Signalkabelstrang 140, während zur Verbindung der Leiterplatten untereinander ein Signalkabelstrang 141 vorgesehen ist. Zur Herstellung einer Leitungsverbindung für die Energieübertragung vom im Schalenkern 137 sitzenden Spulenkörper zum zugehörigen Schaltungsteil auf den Leiterplatten dient eine Steckverbindung 142, 143. Der Stecker 142 sitzt am Rückteil 119; der Stecker 143 ist auf der Leiterplatte 120 angeordnet. Im montierten Zustand kann das gesamte Gebilde der Figur 8 in das hochisolierende Mantelgehäuse 94 des Einschubes von der Frontseite her eingeschoben werden. Es entsteht somit ein Einschub, wie er in der Figur 5 dargestellt ist.

Die Figur 9 zeigt im Ausschnitt eine Koppelstelle für Energieübertragung, wie sie sich darstellt, wenn ein Einschub in seine Endstellung im Isoliergehäuse gebracht ist. Mit 98 ist demnach in gebrochener und geschnittener Darstellung wieder die Rückwand des Einschubgehäuses 94 mit Materialverdünnung 99 im Zentrum dargestellt. Die Materialverdünnung 99 ist auch noch mit einem Zentrierkreuz 144 versehen. Mit 145 ist der Koppelgliedträger bezeichnet. Dieser Träger trägt den schon in der Figur 8 dargestellten einschubseitigen Schalenkern 137 zur Aufnahme des sekundärseitigen Spulenkörpers. Der Schalenkern 137 ist geschlitzt; durch den Schlitz 146 sind gleichzeitig die Anschlussdrähte für den Spulenkern geführt. Der Übertragerträger samt Schalenkern und Spulenkörper ist mittels Haltenippel 147 unter Einschluss einer Feder 148 am Rückteil 119 federnd aufgehängt. Ein Sicherungsring 149 sichert die Anordnung gegen Herausfallen.

Eine ähnliche Bauweise bietet auch die Aufhängung des Koppelgliedes auf der Seite des Gerätes. Mit 57 ist wieder die Rückplatte des Isoliergehäuses 13 dargestellt. Die Rückplatte 57 trägt entsprechend Figur 3 z.B. den Montagezylinder 62 mit Schulter 64 und Zentriersteg 65 der Stegverdünnung des Oberrandes. Auf dem so gestalteten Oberrand des Aufnahmezylinders 62 sitzt die Montageplatte 151 für einen geräteseitigen Koppelgliedträger 152 mit montiertem Schalenkern 153 mit Schlitz 154 für den geräteseitigen Spulenkörper. Der Koppelgliedträger 152 ist wieder mittels Haltenippel 155 und Feder 156 sowie Sicherungsring 157 schwimmend an der Montageplatte 151 aufgehängt. Träger der Montageplatte 151 ist eine Leiterplatte 159, die die für Energie- und Signalübertragung nötigen elektronischen Bauelemente trägt. Zur Befestigung der Montageplatte auf der Leiterplatte dient ein Schnappnippel 158, der in die Leiterplatte einfach eingeschnappt wird. Zur Sicherung gegen Verdrehung dient zwischen Übertragerträger und Montageplatte wieder ein Montagestift 160 und zwischen Montageplatte und Leiterplatte ein Stift 161, während 162 eine sehr dünne Dichtfolie ist, die über die Innenfläche der Rückplatte 57 gespannt ist.

Mit der Erfindung wird also nicht nur erreicht, dass auch bei grossvolumiger bzw. grossflächiger Ausbildung der Einsteckverbindung Koppelkapazitäten zwischen Metallteilen im Inneren der Einschübe und Metallteilen im Inneren des Gerätegehäuses so klein wie möglich gehalten werden, so dass auch der Ableitstrom vernachlässigbar klein wird; durch die besondere Formgebung des Isolierkörpers und durch dessen besonders funktionsgerechten Zusammenbau mit weiteren Bauteilen, wie z.B. Auswerfmechanismus in Verbindung mit Arretiervorrichtung, bauliche Zuordnung der Einzelbestandteile jeder Koppelstelle zueinander etc., ist darüber hinaus ein Gerät geschaffen, das im Sinne der Erfindung optimal und platzsparend einsetzbar ist.

**Patentansprüche**

1. Gerät zum Erfassen und Verarbeiten von elektrischen Signalen mit einem Gerätegehäuse (1), das ein Signalverarbeitungsteil enthält und das wenigstens eine Einbuchtung (12) aufweist, in die wenigstens ein Signalübertragungsteil mit einem Einschiebgehäuse (15, 16, 17, 18) mit einem Mantel (94) aus Isolationsmaterial hoher Spannungsfestigkeit einschiebbar ist, wobei sowohl die Einbuchtung (12) als auch das Einschiebgehäuse (15, 16, 17, 18) Träger von einander zugeordneten Primär- und Sekundärkoppelgliedern (138, 139; 137, 153) einer galvanisch getrennten Koppelstelle für Energie- und/oder Signalübertragung sind, welche Koppelglieder (138, 139; 137, 153) sich erst zur galvanisch getrennten Koppelstelle zusammenfügen, wenn das Einschiebgehäuse (15, 16, 17, 18) in die Einbuchtung (12) eingeschoben ist, dadurch gekennzeichnet, dass die Einbuchtung (12) im Gerätegehäuse (1) mit einem Isolierkörper (13) aus Isolationsmaterial hoher Spannungsfestigkeit ausgekleidet ist oder dass ein solcher Isolierkörper (13) selbst die Einbuchtung (12) bildet, dass der Innenraum des Isolierkörpers (13) durch Längsschienen (43 bis 46) in eine Anzahl von Etagen gegliedert ist, die jeweils zur Aufnahme eines der Einschiebgehäuse (15, 16, 17, 18) bestimmt sind, und dass der Isolierkörper (13) an seinem Umfang Rippen (36) aufweist, die einen vorgegebenen Isolationsabstand zwischen der Innenwand des Isolierkörpers (13) und der Umgebung festlegen.

2. Gerät nach Anspruch 1, dadurch gekennzeichnet, dass die Einbuchtung (12) aus einem nicht magnetischen, jedoch elektrisch leitenden Material, z.B. Aluminium- oder Stahlblech, gebildet und mit dem Isolierkörper (13) ausgekleidet ist, oder dass der Isolierkörper (13), der selbst die Einbuchtung bildet, an seinen Aussenwandungen wenigstens teilweise, vorzugsweise jedoch allseitig, mit Platten (3, 4, 5, 6, 7, 9) aus einem nicht magnetischen, jedoch elektrisch leitenden Material, z.B. Aluminium- oder Stahlblech, zur Abschirmung ummantelt ist.

3. Gerät nach Anspruch 2, dadurch gekennzeichnet, dass die Rippen (36) die Innenwandung des Isolierkörpers (13) unter Einschluss von Isolierschichten aus Luft im vorgegebenen Abstand vom elektrisch leitenden Material der Einbuchtung (12) bzw. von den den Isolierkörper (13) als Einbuchtung umkleidenden Platten (3 bis 7, 9) halten, wobei der Isolierkörper (13) aus ausgesuchtem Isoliermaterial mit bestimmter Dielektrizitätskonstante, z.B. aus Amino-Butadien-Styrol (ABS), so geformt ist, dass er die zwischen Metallteilen innerhalb und Metallteilen ausserhalb des Isolierkörpers (13) herrschende Kapazität auf ein Minimum, z.B. kleiner als 130 pF bei 220 V und 50 Hz, begrenzt.

4. Gerät nach einem der Ansprüche 1 bis 3, dadurch gekennzeichnet, dass der Isolierkörper (13) als frontseitig offener Kasten ausgebildet ist, dessen Innenraum in die einzelnen Etagen gegliedert ist, die zur Aufnahme einer Mehrzahl der hochisolierten Einschiebgehäuse (15 bis 18) dienen, und der vorzugsweise Aussenabmessungen aufweist, die in das Zollmass, z.B. 2/8″-Einschubmass, eines herkömmlichen Gerätegehäuses passen, und dass die Einschiebgehäuse (15 bis 18) jeweils Bestandteil selbständiger Signalübertragungsteile sind und über wenigstens je ein Signalkabel mit wenigstens je einer zugeordneten Signalquelle, insbesondere mit einem Abnehmer für physiologische Messsignale, fest verbunden sind oder wenigstens einen Steckanschluss (19 bis 22) zum Anschliessen eines solchen Signalkabels aufweisen.

5. Gerät nach einem der Ansprüche 1 bis 4, dadurch gekennzeichnet, dass der Isolierkörper (13) aus zwei Halbschalen (34, 35) gebildet ist, die bei Zusammensetzung ein front- und rückseitig offenes Kastengehäuse bilden, und dass das Kastengehäuse an zwei gegenüberliegenden Kanten, vorzugsweise Hochkanten, der offenen Rückfläche je eine Einschiebnut (41, 42) aufweist, in die zur Abdeckung der offenen Rückfläche des Kastens eine isolierte Rückplatte (57), vorzugsweise aus ABS, einschiebbar ist, die gleichzeitig Träger der dem Signalverarbeitungsteil im Gerätegehäuse (1) zuzuordnenden Primär- und Sekundärkoppelglieder ist.

6. Gerät nach Anspruch 5, dadurch gekennzeichnet, dass die beiden Halbschalen (34, 35) zusammen mit der in die Einschiebnuten (41, 42) einschiebbaren Rückplatte (57) zu einem nur frontseitig offenen Kasten montiert sind in der Weise, dass die beiden Halbschalen an ihren Aneinandersetzleisten mit nur zwei Schrauben verschraubt sind, wozu je zwei passende Schraublöcher (39) im Bereich der Frontöffnung (14) an Deck- und Bodenfläche vorhanden sind, und dass im Bereich der Hinterkante der Deckfläche in den Ecken passend zu Ecklöchern an der Oberkante der Rückplatte (57) zwei weitere Schraublöcher (40) zum Verschrauben der Oberkante der Rückplatte (57) mit den oberen Rückkanten der Halbschalen (34, 35) vorgesehen sind, während die hinteren Unterkanten der Halbschalen (34, 35) über Schrägflächen (60, 61) der Einschiebnuten (41, 42), in die die Eckkanten der Rückplatte (57) eingreifen, nach Keildruckart selbsttätig zusammengepresst werden.

7. Gerät nach Anspruch 5 oder 6, dadurch gekennzeichnet, dass die Rückplatte (57) in Reihe übereinander für jeden in den Isolierkasten (13) einzuschiebenden Einschub (15 bis 18) einen Aufnahmeraum (62, 63 etc.) für einen Übertragerkörper (152 bis 154) aufweist, der jeweils ein Halbteil einer Koppelstelle für die Energieübertragung abgibt, deren anderes Halbteil (137, 145, 146) im jeweiligen Einschub (15–18) sitzt.

8. Gerät nach Anspruch 7, dadurch gekennzeichnet, dass der obere, der Rückplatte (57) abgewandte Rand des jeweiligen Aufnahmeraumes (62, 63 etc.) für einen Übertragerkörper stegartig verdünnt ist, wobei die Schulter (64) der Stegverdünnung als Auflage für eine Montageplatte (151) mit dem Oberrandsteg (65) als Montageplatten-Zentriermittel dient, welche Montageplatte (151) wiederum Träger der Übertragerkörper (152 bis 154) zur Einlegung in die Aufnahmeräume (62, 63 etc.) ist.

9. Gerät nach Anspruch 8, dadurch gekennzeichnet, dass die Übertragerkörper (152 bis 154) an der Montageplatte (151) und vorzugsweise auch der Übertragerkörper (137, 145, 146) am jeweiligen Einschub (15 bis 18) schwimmend und federnd befestigt sind.

10. Gerät nach Anspruch 8 oder 9, dadurch gekennzeichnet, dass die Montageplatte (151) von einer Leiterplatte (159) getragen ist, auf der die für Energieübertragung und/oder Signalübertragung erforderlichen elektronischen Bauelemente montiert sind, und dass die Rückplatte (57) des Isoliergehäuses (13) Nischen (66, 67 etc.) bzw. Einsätze (68, 69 etc.) aufweist, die zur Aufnahme von Lichtempfängern, z.B. im Infrarotbereich wirkenden Fotodioden, bei Signalübertragung vom Einschub zum Gerät und von Lichtsendern, z.B. im Infrarotbereich wirkenden Lumineszenzdioden, bei Signalübertragung vom Gerät zum Einschub dienen, wobei jedem Lichtempfänger auf der Seite der Rückplatte als sekundäres Halbteil der Signalkoppelstelle ein Lichtsender als primäres Halbteil auf der Seite des Einschubes bzw. einem Lichtsender als primäres Halbteil der Signalkoppelstelle auf der Seite der Rückplatte ein Lichtempfänger als sekundäres Halbteil auf der Seite des Einschubes zugeordnet sind.

11. Gerät nach einem der Ansprüche 4 bis 10, dadurch gekennzeichnet, dass jedem Einschub (15 bis 18) ein Auswerfmechanismus (Fig. 7) im Innern des Isolierkörpers (13) zugeordnet ist, der in Aktion tritt, wenn eine Arretiervorrichtung (Fig. 4), die den Einschub (15–18) im Isolierkörper (13) nach Einschieben arretiert, durch manuelle Betätigung einer am Gerätegehäuse (1) angeordneten Ausklinktaste (30 bis 33) gelöst wird.

12. Gerät nach Anspruch 11, dadurch gekennzeichnet, dass für jeden Einschub (15 bis 18) ein aus Stossglied (103, 104, 105 etc.) mit Druckfeder (109, 110, 111 etc.) bestehender Auswerfmechanismus an der Rückplatte (57) des Isolierkastens (13) angeordnet ist in dem Sinne, dass ein im Isolierkörper (13) in Arretierstellung gebrachter Einschub (15–18) das Stossglied (102, 104, 105) gegen den Druck der zugeordneten Druckfeder wegdrückt, und zwar so lange, bis mit Lösen der Arretierung die gespannte Feder (189) über das Stossglied den Einschub um eine bestimmte Wegstrecke aus der Öffnung des Isolierkörpers (13) auswirft, und dass die Arretiervorrichtung für jeden Einschub (15 bis 18) ein Hebelsystem mit Klinkhebel (73, 74, etc.) umfasst, welches Hebelsystem an einer Seitenwand des Isolierkörpers (13) angeordnet ist und dessen Klinkhebel in eine Festhaltenut (96) am Umfang des Einschubes (15 bis 18) eingreift, wenn der Einschub im Innern des Isolierkörpers (13) in seine Endstellung gebracht ist.

13. Gerät nach einem der Ansprüche 4 bis 12, dadurch gekennzeichnet, dass der Isolierkörper (13) zur Aufnahme von Geräteeinschüben (15 bis 18) ausgebildet ist, die ein Mantelgehäuse (94) aus hochisolierendem Kunststoff, z.B. ABS, umfassen, in dessen Innern eingebettet in metallischen Abschirmblechen (122, 123) die Bauteile für Energie- und Signalübertragung in Form eines Manteleinschubes einsetzbar sind.

14. Gerät nach Anspruch 13, dadurch gekennzeichnet, dass der Mantel (94) eines jeden Einschubes (15 bis 18) wohlgerundete Gleitrinnen (95) anstelle von Längskanten aufweist, die zu den etagenmässig an der Innenwand des Isolierkörpers (13) angeordneten Längsschienen (43 bis 46) passen, die so geformt sind, dass auf eine relativ flache Wandauswölbung (47) als Seitenwandführung ein stärker ausgewölbter Längssteg (48) als Schienenauflage für den Einschub (15 bis 18) folgt.

15. Isolierter Einschub (15 bis 18) von hoher Spannungsfestigkeit zum Einschieben in die Einbuchtung (12) eines Gerätegehäuses (1), mit einem Mantelgehäuse (94) aus hochisolierendem Kunststoff, mit einer metallischen Abschirmung (122, 123) innerhalb des Mantelgehäuses (94) und mit Bauelementen (138, 139; 134, 153) innerhalb der Abschirmung (122, 123), die zur galvanisch getrennten Energie- und/oder Signalübertragung vorgesehen sind, dadurch gekennzeichnet, dass das Mantelgehäuse (94) aussen mit sich in Einschubrichtung erstreckenden, an den Längskanten befindlichen Gleitrinnen (95) versehen ist (Fig. 5).

16. Einschub nach Anspruch 15, dadurch gekennzeichnet, dass die Gleitrinnen (95) abgerundet sind (Fig. 5).

17. Einschub nach einem der Ansprüche 15 oder 16, dadurch gekennzeichnet, dass das Mantelgehäuse (94) aus Amino-Butadien-Styrol (ABS) gebildet ist.

18. Einschub nach einem der Ansprüche 15 bis 17, dadurch gekennzeichnet, dass das Mantelgehäuse (94) nur frontseitig offen ist und dort eine Frontöffnung besitzt, die durch eine Frontplatte (118) verschlossen ist, wobei die Frontplatte (118) in ihren Abmessungen dicht in die Frontöffnung passt (Fig. 5, 8).

19. Einschub nach einem der Ansprüche 15 bis 18, dadurch gekennzeichnet, dass das Mantelgehäuse (94) eine Rückwand (98) aufweist, die Koppelelemente (100, 101, 137) für die Energie- und/oder Signalübertragung trägt (Fig. 6, 9).

20. Einschub nach einem der Ansprüche 15 bis 19, dadurch gekennzeichnet, dass das Mantelgehäuse (94) eine Frontwand (118) aufweist, die einen Anschluss (19 bis 22) für ein Signalkabel besitzt.

21. Einschub nach einem der Ansprüche 15 bis 20, dadurch gekennzeichnet, dass das Mantelgehäuse (94) aussen mindestens eine Einklinknut (96) aufweist, die zum Einklinken einer Arretiernase im eingeschobenen Zustand des Einschubs innerhalb der Einbuchtung (12) vorgesehen ist (Fig. 5).

**Claims**

1. Apparatus for detecting and processing electrical signals comprising a housing (1), which contains a signal processing component and which has at least one recess (12), into which can be inserted at least one signal transmission component, having an insertable housing (15, 16, 17, 18) and a casing (94) made of an insulating material of high dielectric strength, where the recess (12) and the insertable housing (15, 16, 17, 18) are carriers of mutually assigned primary and secondary coupling members (138, 139; 137, 153) of an electrically isolated coupling point for energy and/or signal transmission, which coupling elements (138, 139; 137, 153) are only joined together to form the electrically isolated coupling point when the insertable housing (15, 16, 17, 18) is inserted into the recess (12), characterised in that the recess (12) in the housing (1) is provided with an insulating body (13) made of an insulating material of high dielectric strength, or that an insulating body (13) itself forms the recess (12), which body is such that the internal space of the insulating body (13) is divided into a plurality of levels by longitudinal rails (43 to 46), which levels respectively serve to accomodate one of the insertable housings (15, 16, 17, 18); and that at its periphery the insulating body (13) has ribs (36) which set a predetermined insulating distance between the inner wall of the insulating body (13) and the surroundings.

2. Apparatus as claimed in Claim 1, characterised in that the recess (12) is made of a non-magnetic but electrically-conductive material, e.g. aluminium or steel plate, and is provided with the insulating body (13); or that the insulating body (13), which itself forms the recess, has its outer walls sheathed for screening with plates (3, 4, 5, 6, 7, 9) made of a non-magnetic, but electrically-conductive material, e.g. aluminium plate or steel plate.

3. Apparatus as claimed in Claim 2, characterised in that the ribs (36) maintain the inner wall of the insulating body (13), including insulating layers of air, at a predetermined distance from the electrically-conductive material of the recess (12), or the plates (3 to 7, 9) which surround the insulating body (13) as recess, where the insulating body (13) is formed from selected insulating materials having a specific dielectric constant, e.g. from amino-butadiene-styrene (ABS), in such manner that it limits the capacitance which prevails between metal components inside the insulating body (13) and metal components outside the insulating body (13), to a minimum, e.g. to less than 130 pF at 220 V and 50 Hz.

4. Apparatus as claimed in one of Claims 1 to 3, characterised in that the insulating body (13) is in the form of a box which is open at the front and the internal space of which is divided into individual levels which serve to accommodate a plurality of the highly insulated insertable housings (15 to 18), and which preferably has outer dimensions which fit into the measurement in inches, e.g. 2/8" insertion measurement, of a conventional apparatus housing; and that the insertable housings (15 to 18) in each case are components of independent signal transmission elements and are fixedly connected by means of a respective signal cable to at least one respective assigned signal source, in particular to a receiver for physiological measuring signals, or have at least one plug connection (19 to 22) for the connection of a signal cable.

5. Apparatus as claimed in one of Claims 1 to 4, characterised in that the insulating body (13) consists of two half-shells (34, 35) which, when assembled, form a box housing which is open at the front face and at the rear face; and that the box housing has a respective insertion groove (41, 42) at two opposite edges, preferably working edges, of the open rear face, into which an insulated rear plate (57), preferably made of ABS, can be inserted in order to cover the open rear surface of the box, and which rear plate simultaneously represents the carrier of the primary and secondary coupling elements to be assigned to the signal processing component in the housing (1).

6. Apparatus as claimed in Claim 5, characterised in that the two half-shells (34, 35), together with the rear plate (57) which can be inserted into the insertion grooves (41, 42), are assembled to form a box which is open only at the front, in such manner that at their joining edges, the two half-shells are only screwed together by means of two screws, for which purpose two appropriate screw holes (39) are arranged in the region of the front opening (14) in the top and bottom surfaces; and that in the region of the rear edge of the top surface, two further screw holes (40) for screwing together the upper edge of the rear plate (57) and the upper rear edges of the half-shells (34, 35), are arranged in the corners so as to fit the corner holes on the upper edge of the rear plate (57), whilst the rear lower edges of the half-shells (34, 35) are automatically pressed together by wedging pressure, through transverse surfaces (60, 61) of the insertion grooves (41, 42), into which the corner edges of the rear plate (57) engage.

7. Apparatus as claimed in Claim 5 or 6, characterised in that for each insert (15 to 18) which is to be inserted into the insulating box (13), the rear plate (57) has a receiving space (62, 63 etc.) for a transfer body (152 to 154) in series one above another, which bodies (152 to 154) in each case delivers half of a coupling point for energy transmission, the other half (137, 145, 146) being positioned in the respective insert (15–18).

8. Apparatus as claimed in Claim 7, characterised in that the upper edge of each receiving space (62, 63 etc.) for a transport body which faces away from the rear plate (57), is reduced in thickness to form a crossbar, the shoulder (64) of the crossbar of reduced thickness serving as a support for an assembly plate (151) with the upper edge crossbar (65) as a centering means for the assembly plate, which assembly plate (151) carries the transfer bodies (152 to 154) for insertion into the receiving spaces (62, 63 etc.).

9. Apparatus as claimed in Claim 8, characterised in that the transfer bodies (152 to 154) are secured to the assembly plate (151) and preferably each transmitter body (137, 145, 146) is also secured to the respective insert (15 to 18) so as to float and be resilient.

10. Apparatus as claimed in Claim 8 or Claim 9, characterised in that the assembly plate (151) is supported by a printed circuit board (159), on which the electronic components which are required for energy transmission and/or signal transmission are mounted; and that the rear plate (57) of the insulating housing (13) has niches (66, 67 etc.) or inserts (68, 69 etc.) which serve to accomodate light receivers, e.g. photo-diodes effective in the infrared region during signal transmission from the insert to the apparatus, and light transmitters, e.g. luminescent diodes effective in the infrared region, during signal transmission from the apparatus to the insert, where each light receiver on the side of the rear plate as a secondary half of the signal coupling point is assigned a light transmitter as a primary half on the side of the insert, and a light transmitter as a primary half of the signal coupling point on the side of the rear plate is assigned a light receiver as a secondary half on the side of the insert.

11. Apparatus as claimed in one of Claims 4 to 10, characterised in that each insert (15 to 18) is allotted an ejecting mechanism (Fig. 7) within the insulating body (13) which becomes effective if a locking device (Fig. 4) which locks the insert (15–18) in the insulating body (13) after insertion is released by manual operation of a disengaging key (30 to 33) arranged on the apparatus housing (1).

12. Apparatus as claimed in Claim 11, characterised in that for each insert (15 to 18) an ejecting mechanism consisting of a push element (103, 104, 105 etc.) with a pressure spring (109, 110, 111 etc.) is provided on the rear plate (57) of the insulating body (13) in such manner that an insert (15–18) which has been brought into the locking position in the insulating body (13) presses the push element (102, 104, 105) against the pressure of the assigned pressure spring until, by releasing the lock, the tightened spring (189) ejects the insert through the push element by a predetermined distance from the opening of the insulating body (13); and that for each insert (15 to 18), the locking device comprises a lever system with ratchet levers (73, 74 etc.), each said lever system being arranged on a side wall of the insulating body (13) and the ratchet lever of which engages into a retaining groove (96) on the periphery of the insert (15 to 18) when the insert has been brought into its terminal position within the insulating body (13).

13. Apparatus as claimed in one of Claims 4 to 12, characterised in that the insulating body (13) is designed to accomodate apparatus inserts (15 to 18) which comprise a casing (94) made of a highly insulating synthetic resin, e.g. ABS, into the interior of which the components for energy and signal transmission, embedded in metal screening plates (122, 123), can be inserted in the form of a casing insert.

14. Apparatus as claimed in Claim 13, characterised in that the casing (94) of each insert (15 to 18) has well-rounded slide channels (95) in place of longitudinal edges which match the longitudinal rails (43 to 64) which are arranged at the levels on the inner wall of the insulating body and which are so shaped that a strongly curved longitudinal cross-piece (48) serving as a rail support for the insert (15 to 18), follows a relatively flat wall curvature (47) as a lateral wall guide.

15. An insulated insert (15 to 18) of high dielectric strength for insertion into the recess (12) of a housing (1), comprising a sheath housing (94) made of a highly-insulating synthetic resin, a metal screen (122, 123) within the casing (94), and components (138, 139; 134, 153) within the screen (122, 123) provided for the electrically separated energy and/or signal transmission, characterised in that the casing (94) is provided externally with slide channels (95) which extend in the insertion direction and are arranged on the longitudinal edges (Fig. 5).

16. An insert as claimed in Claim 15, characterised in that the slide channels (95) are rounded (Fig. 5).

17. An insert as claimed in one of Claims 15 and 16, characterised in that the casing (94) consists of amino-butadiene-styrene (ABS).

18. An insert as claimed in one of Claims 15 to 17, characterised in that the casing (94) is open only at the front and has a front opening which is closed by a front plate (118), the front plate (118) fitting tightly into the front opening in respect of its dimensions (Fig. 5, 8).

19. An insert as claimed in one of Claims 15 to 18, characterised in that the casing (94) has a rear wall (98) which supports coupling elements (100, 101, 137) for energy and/or signal transmission (Fig. 6, 9).

20. An insert as claimed in one of Claims 15 to 19, characterised in that the casing (94) has a front wall (118) which has a connection (19 to 22) for a signal cable.

21. An insert as claimed in one of Claims 15 to 20, characterised in that the casing (94) has externally at least one engaging channel (96) which is provided for engaging a locking projection in the inserted state of the insert within the recess (12), (Fig. 5).

## Revendications

1. Appareil pour la saisie et le traitement de signaux électriques avec un boîtier d'appareil (1) qui contient un élément pour le traitement des signaux et qui comporte au moins une cuvette (12) dans laquelle est susceptible d'être inséré au moins un élément de transmission avec un tiroir (15, 16, 17, 18) avec une enveloppe (94) faite avec un matériau isolant de grande rigidité électrique, la cuvette (12) ainsi que le tiroir (15, 16, 17, 18) étant des supports d'éléments de couplage primaire et secondaire associés (138, 139; 137, 153) d'un point de couplage, galvaniquement séparé, pour la transmission de l'énergie et/ou des signaux desdits éléments de couplage (138, 139; 137, 153) ne s'assemblant, pour former le point de couplage galvaniquement séparé, que lorsque le tiroir (15, 16, 17, 18) est inséré dans la cuvette (12), caractérisé par le fait que la cuvette (12) ménagée dans le boîtier d'appareil (1) est revêtue d'un corps isolant (13) en un matériau de forte rigidité diélectrique, ou qu'un tel corps isolant (13) forme lui-même la cuvette (12), que l'espace intérieur du corps isolant (13) est subdivisé par des rails longitudinaux (43 à 46) en un certain nombre d'étages dont chacun est destiné à recevoir l'un des tiroirs (15, 16, 17, 18) et que le corps isolant (13) comporte sur sa périphérie des nervures (36) qui définissent une distance du corps isolant (13) et l'environnement.

2. Appareil selon la revendication 1, caractérisé par le fait que la cuvette (12) est formée avec un matériau non-magnétique, mais électriquement conducteur, par exemple avec de la tôle d'aluminium ou d'acier et qu'elle est revêtue du corps isolant (13), ou que les parois extérieures du corps isolant (13) qui forme lui-même la cuvette, sont, pour former écran, revêtues au moins partiellement, mais de préférence de tous côtés, de plaques (3, 4, 5, 6, 7, 9) d'un matériau non-magnétique mais électriquement conducteur, par exemple de tôle d'aluminium ou d'acier.

3. Appareil selon la revendication 2, caractérisé par le fait que les nervures (36) maintiennent, avec inclusion de couches isolantes formées par de l'air, la paroi intérieure du corps isolant (13) à une distance prédéterminée du matériau électriquement conducteur de la cuvette, ou des plaques (3 à 7, 9) qui revêtent le corps isolant (13) formant la cuvette, le corps isolant (13) étant formé de telle manière avec un matériau isolant selectionné, possédant une consistante diélectrique déterminée, par exemple avec du styrène-butadiène-acrylonitrile (ABS), qui limite à un minimum, par exemple à moins de 130 pF, à 220 V et à 50 Hz, la capacité qui règne entre les parties métalliques situées à l'intérieur du corps isolant et les parties métalliques situées à l'extérieur du corps isolant (13).

4. Appareil selon l'une des revendications 1 à 3, caractérisé par le fait que le corps isolant (13) est réalisé sous la forme d'une boîte frontalement ouverte, dont l'espace intérieur est subdivisé en les différents étages qui servent à recevoir une pluralité de tiroirs (15 à 18) fortement isolés et dont les dimensions extérieures sont de préférence adaptées à la dimension en pouces, par exemple à la dimension des tiroirs 2/8'' d'un boîtier d'appareil courant, et que les tiroirs (15 à 18) sont chacun un élément constitutif d'éléments individuels pour la transmission de signaux et sont reliés de façon fixe, et respectivement par l'intermédiaire d'au moins un câble, à au moins une source de signaux associée, en particulier à un élément de prélèvement de signaux physiologique ou au moins à une prise à enfichage (19 à 22) pour le raccordement d'un tel câble.

5. Appareil selon l'une des revendications 1 à 4, caractérisé par le fait que le corps isolant (13) est formé par deux demi-coquilles (34, 35) qui, lors de leur assemblage, forment une boîte ouverte sur le côté frontale et sur le côté arrière, et que la boîte possède sur chacun des bords opposés, de préférence sur les bords élevés, de la surface arrière, une rainure d'insertion (41, 42) dans laquelle on peut engager, pour la fermeture de la surface arrière ouverte de la boîte, une plaque arrière isolée (57), de préférence en ABS, laquelle plaque est en même temps porteuse des éléments de couplage primaire et secondaire, qui sont associés, dans le boîtier d'appareil, à l'élément pour le traitement des signaux.

6. Appareil selon la revendication 5, caractérisé par le fait que les deux demi-coquilles (34, 35) sont montées, avec la plaque arrière (57) qui est susceptible d'être insérée dans les rainures d'insertion (41, 42), pour former une boîte frontalement ouverte, et cela de telle manière que les deux demi-coquilles sont vissées avec seulement deux vis à leur réglette de démontage, ce pourquoi on prévoit deux trous de vissage (39), au niveau de l'ouverture frontale (14), dans la surface de couvercle et dans la surface de fond, et qu'au niveau du bord arrière de la surface de couvercle, on prévoit, dans les sommets et de manière à coïncider avec des trous sommitaux ménagés dans le bord supérieur de la plaque arrière (57), deux autres trous à vis (40) pour visser le bord supérieur de la plaque arrière (57) aux bords postérieurs supérieurs des demi-coquilles (34, 35), alors que les bords inférieurs arrières des demi-coquilles (34, 35) sont assemblées automatiquement avec pression par des surfaces cunéiformes, à l'aide de surfaces obliques (60, 61) des gorges d'insertion (41, 42) dans lesquelles pénètrent les bords sommitaux de la plaque arrière (57).

7. Appareil selon la revendication 5 ou 6, caractérisé par le fait que la plaque arrière (57) comporte, suivant une rangée superposée et pour chacun des tiroirs (15 à 18) à insérer dans le boîtier isolant (13), un espace de réception (62, 63, etc...) pour un corps de transmission (152 à 154), fournissant une moitié du point de couplage pour la transmission de l'énergie, l'autre moitié (137, 145, 146) se situant dans le tiroir correspondant (15/18).

8. Appareil selon la revendication 7, caractérisé par le fait que le bord supérieur, éloigné de la plaque arrière (57), de l'espace de réception (62, 63, etc...) pour un corps de transmission, est aminci en forme de barrette, l'épaulement (64) de l'amincissement en barrette servant d'appui pour une plaque de montage (151), avec la barrette de bordure supérieure (65) comme moyen de centrage de la plaque de montage (151), celle-ci constituant à son tour le support des corps de transmission (152 à 154) pour l'introduction dans les espaces de réception (62, 63, etc...).

9. Appareil selon la revendication 8, caractérisé par le fait que les corps de transmission (152 à 154) sont fixés de façon flottante et élastique à la plaque de montage (151) et, de préférence, il en est également de même pour les corps de transmission (137, 145, 146) sur le tiroir correspondant (15 à 18).

10. Appareil selon la revendication 8 ou 9, caractérisé par le fait que la plaque de montage (151) est portée par une plaque conductrice (159) sur laquelle sont montés les composants électroniques qui sont nécessaires pour la transmission de l'énergie et/ou pour la transmission des signaux, et que la plaque arrière (57) du boîtier isolant (13) comporte des niches (66, 67, etc...) ou des inserts (68, 69, etc...) qui servent à recevoir des photo-récepteurs, par exemple des photodiodes agissant dans la plage des infra-rouges, dans le cas de la transmission de signaux du tiroir à l'appareil et de photo-émetteurs, par exemple de diodes à luminescence agissant dans la zone infrarouge, dans le cas de la transmission de signaux de l'appareil au tiroir, étant noté qu'à chaque photo-récepteur est associé, sur le côté de la plaque arrière et en tant que demi-éléments secondaires du point de couplage des signaux, un photo-émetteur constituant le demi-élément primaire du côté du tiroir ou à chaque photo-émetteur étant associé, en tant que demi-élément primaire du point de couplage des signaux, sur le côté de la plaque arrière, un photo-récepteur constituant la demi-partie secondaire du côté du tiroir.

11. Appareil selon l'une des revendications 4 à 10, caractérisé par le fait qu'à chaque tiroir (15 à 18) est associé un mécanisme d'éjection (figure 7), à l'intérieur du corps isolant (13), lequel mécanisme d'éjection entre en action lorsqu'un dispositif de blocage (figure 4) qui bloque le tiroir (15–18) dans le corps isolant (13), après son insertion, est débloqué par commande manuelle d'une touche de dégagement (30 à 33) qui est disposée sur le boîtier d'appareil (1).

12. Appareil selon la revendication 11, caractérisé par le fait que sur la plaque arrière (57) du corps isolant (13) il est prévu, pour chaque tiroir (15 à 18), un mécanisme d'éjection qui est constitué par un poussoir (103, 104, 105, etc...) à un ressort de pression (109, 110, 111, etc...), l'agencement étant tel qu'un tiroir (15–18) qui a été amené dans la position de blocage dans le corps isolant (13) refoule le poussoir (102, 104, 105), à l'encontre de la force du ressort de pression associé, et cela jusqu'à ce que, avec la libération du dispositif de blocage, le ressort armé éjecte, par l'intermédiaire du poussoir, le tiroir d'une certaine quantité hors de l'ouverture du corps isolant (13) et que le dispositif de blocage pour chaque tiroir (15 à 18) comprend un système à leviers avec cliquets (73, 74, etc...) lequel système à leviers est disposé sur une paroi latérale du corps isolant (13) alors que son cliquet pénètre dans une gorge de retenue (96) prévue à la périphérie du tiroir (15 à 18), lorsque le tiroir est amené dans sa position d'extrémité à l'intérieur du corps isolant (13).

13. Appareil selon l'une des revendications 4 à 12, caractérisé par le fait que le corps isolant (13) est réalisé pour recevoir des tiroirs (15 à 18) qui comprennent une enveloppe (94) constituée par une matière plastique fortement isolante, par exemple par du ABS, et à l'intérieur de laquelle enveloppe sont susceptibles d'être insérés, sous la forme d'un tiroir-enveloppe, tout en étant noyés dans des tôles métalliques formant écran (122, 123), les éléments consécutifs pour la transmission de l'énergie et des signaux.

14. Appareil selon la revendication 13, caractérisé par le fait que l'enveloppe (94) de chaque tiroir (15 à 18) comporte, à la place de bords longitudinaux, des gorges de glissement arrondies (95) qui sont adaptées aux rails longitudinaux (43 à 46) disposés en étage sur la paroi intérieure du corps isolant (13), et qui sont conformés de telle façon qu'à un bombement (47) saillant sur la paroi et relativement plat pour servir de guidage de la paroi latérale, fait suite une barrette longitudinale plus fortement bombée (48) servant d'appui de rail pour le tiroir (15 à 18).

15. Tiroir isolé (15 à 18) de forte rigidité diélectrique pour l'insertion dans la cuvette (12) d'un boîtier d'appareil (1), avec une enveloppe (94) faite avec un matériau fortement isolant, avec un écran métallique (122, 123) à l'intérieur de l'enveloppe (84) et avec des composants (138, 139; 134, 153) à l'intérieur de l'écran (122, 123) et qui sont prévus pour la transmission, avec séparation galvanique de l'énergie et/ou des signaux, caractérisé par le fait que l'enveloppe (84) est pourvue extérieurement de gorges de coulissement (95) ménagées dans les bords longitudinaux et s'étendant dans la direction de l'insertion (figure 5).

16. Tiroir selon la revendication 15, caractérisé par le fait que les gorges de glissement (95) sont arrondies (figure 5).

17. Tiroir selon l'une des revendications 15 ou 16, caractérisé par le fait que l'enveloppe (94) est formée avec du amino-butadiène-styrène (ABS).

18. Tiroir selon l'une des revendications 15 à 17, caractérisé par le fait que l'enveloppe (94) n'est ouverte que du côté frontal et y possède une ouverture frontale qui est fermée par une plaque frontale (118), ladite plaque frontale (118) ayant des dimensions qui s'adaptent étroitement à l'ouverture frontale (figure 5, 8).

19. Tiroir selon l'une des revendications 15 à 18, caractérisé par le fait que l'enveloppe (94) possède une paroi arrière (98) qui porte les éléments de couplage (100, 101, 137) pour la transmission de l'énergie et/ou des signaux (figures 6, 9).

20. Tiroir selon l'une des revendications 15 à 19, caractérisé par le fait que l'enveloppe (94) possède une paroi frontale (118) qui possède un raccord (19 à 22) pour câble pour signaux.

21. Tiroir selon l'une des revendications 15 à 20, caractérisé par le fait que l'enveloppe (94) possède extérieurement au moins une gorge d'encliquetage (96) qui est prévue pour la pénétration d'un bec de blocage à l'état inséré du tiroir dans la cuvette (12) (figure 5).

FIG 1

0 040 754

FIG 2

FIG 3

FIG 4

FIG 6

FIG 5

0 040 754

FIG 7

FIG 9

FIG 8

0 040 754